# FASCICULE DE BREVET EUROPEEN

(11) **EP 4 490 525 B1**
(45) Date de publication et mention de la délivrance du brevet: **14.01.2026**
(21) Numéro de dépôt: 23713717.9
(22) Date de dépôt: 09.03.2023
(51) Int. Cl.: G01R 31/00, G01R 31/12

(54) **DÉTECTION D'ARC ÉLECTRIQUE PAR RÉSEAU DE BRAGG**
DETEKTION EINES LICHTBOGENS MITTELS EINES BRAGG-GITTERS
DETECTING AN ELECTRIC ARC BY MEANS OF A BRAGG GRATING

(30) Priorité: 10.03.2022 FR 2202082
(43) Date de publication de la demande: 15.01.2025
(73) Titulaire: SAFRAN, 75015 Paris (FR)
(72) Inventeur: BUSSY, Emmanuel, 77550 MOISSY-CRAMAYEL (FR)
(74) Mandataire: Ernest Gutmann - Yves Plasseraud S.A.S.
(86) Numéro de dépôt international: PCT/FR2023/050317
(87) Numéro de publication internationale: WO 2023/170368

(56) Documents cités:
- CN-A- 111 751 685
- FR-A1- 3 056 966
- US-A1- 2010 321 838

## Description

### Domaine technique

Le présent document se place dans le cadre d'une détection d'arcs électriques en environnement aéronautique.

### Technique antérieure

Dans le domaine aéronautique, les aéronefs sont équipés de chaînes de distribution électrique permettant d'alimenter les équipements tels que les commandes de vols et des charges associées à la vie à bord. Plus récemment, l'hybridation électrique de la propulsion fait l'objet d'études pour lesquelles les chaînes électriques sont fortement impliquées.

La chaîne électrique est composée d'un système de génération de puissance, appelé source assurant la disponibilité de la puissance à répartir sur l'ensemble des charges. Pour assurer cette répartition, la chaîne électrique est également composée de meubles de distribution assurant les rôles de routage, de protection, de coupure et d'interconnexion. Ensuite, la chaîne électrique dispose d'un système de distribution électrique appelé Système d'Interconnexion de Câblage Electrique ou encore en anglais EWIS : *Electrical Wiring Interconnection System.* Celui-ci est composé de harnais de distribution, appelés aussi routes. Une route de distribution définit un ou plusieurs câbles d'un harnais assurant l'alimentation d'une charge électrique. Chaque route est équipée en amont, au niveau du meuble de distribution par exemple, d'un système de protection et de coupure. Usuellement, les systèmes de protection réalisent un diagnostic de santé électrique des lignes par une mesure de courant de ligne à partir de capteurs dédiés. Les harnais sont composés de câbles électriques dimensionnés pour transporter le courant, d'interfaces électriques, tels que des connecteurs ou borniers électriques et des éléments mécaniques associés soit à la protection passive des harnais, tels que des gaines, soit à l'installation des harnais dans la structure des aéronefs, tels que des colliers de serrage et de maintien. Enfin, en bout de route, les câbles sont connectés aux charges électriques dont ils assurent l'alimentation.

Ces routes de distribution sont ainsi présentes entre la source et un meuble de distribution, éventuellement entre un meuble de distribution primaire et un meuble de distribution secondaire et enfin entre un meuble de distribution et une charge électrique. Chaque route est donc équipée à minima de deux interfaces électriques, type connecteur ou bornier. La première interface électrique est située en amont de la route, la seconde en aval, permettant ainsi de relier les équipements amont et aval auxdites routes. Dans certains cas, ces routes sont également équipées d'interfaces intermédiaires divisant ainsi lesdites routes en plusieurs tronçons.

La chaîne électrique est sujet à l'apparition de phénomènes physiques. Les composants et systèmes dédiés au transport électrique sont spécifiés pour s'affranchir de ces phénomènes redoutés. Néanmoins, certaines causes peuvent être à l'origine de leur apparition. Citons par exemple le vieillissement provoqué entre autres par des contraintes environnementales ou des facteurs extérieurs humains ou autres. L'arc électrique de défaut est l'un de ces phénomènes.

Une décharge électrique apparaît lorsqu'un gaz est soumis à un champ électrique dépassant une tension de claquage, dite tension disruptive. Un arc électrique est une décharge disruptive à fort courant et auto-entretenue à de faibles niveaux de tensions. L'arc électrique est le siège d'interactions physico-chimiques au sein d'un gaz fortement ionisé conduisant parfaitement le courant. Un arc électrique de défaut est un arc électrique inopportun pouvant apparaître sur chacun des composants de la chaîne électrique de distribution suite à des défaillances de l'un ou plusieurs de ces composants. Par exemple, il est connu que des interactions chimiques, électriques ou mécaniques sont des causes principales de modes de défaillance aboutissant à la génération d'arcs électriques de défaut.

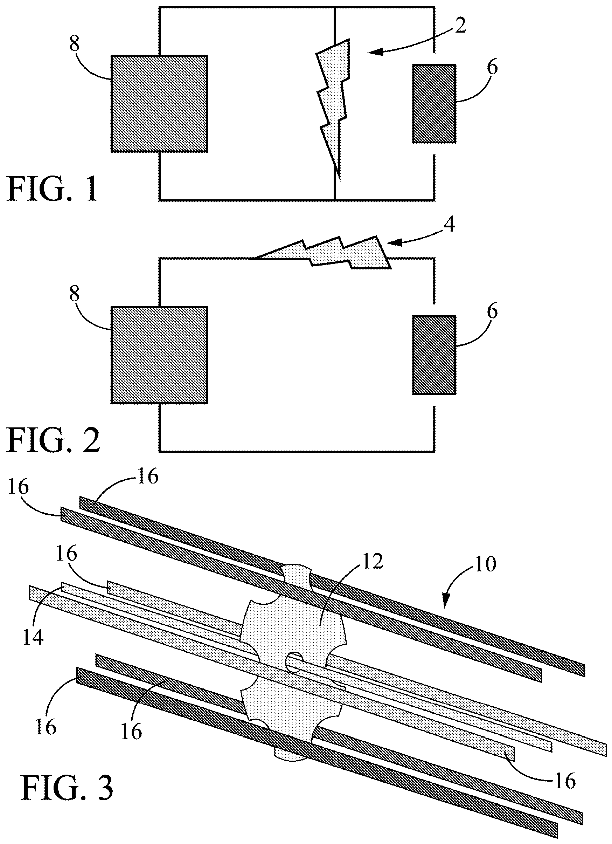

Comme illustré aux figures 1 et 2, Il existe deux types d'arcs électriques de défaut. Le premier appelé arc parallèle 2 est un arc électrique venant se créer entre deux conducteurs électriques aux potentiels différents alimentés par une source 8. Par exemple, un arc électrique parallèle 2 peut apparaître entre deux phases ou entre une phase et une masse. Il est la conséquence de la rupture de la tenue diélectrique entre ces conducteurs. Cette rupture est la conséquence de dégradations des isolants et de la diminution de la distance entre électrodes par exemple par insertion d'un matériel extérieur conducteur liquide ou solide. L'arc électrique parallèle 2 provoque alors une continuité électrique de très basse impédance en parallèle de la charge électrique 6, venant quasiment la court-circuiter. En pratique, il est généralement facile à observer en réalisant une mesure de courant de ligne, car il induit un fort appel de courant durant la durée de l'arc. Le second type d'arc de défaut est l'arc série 4. Il est issu d'une discontinuité au sein de la boucle de courant entre la source 8 et la charge électrique 6. Typiquement, l'arc électrique série 4 intervient localement au sein des interfaces électriques amont, aval ou intermédiaires. Il est la conséquence de modes de défaillances de ces interfaces telles qu'une déconnexion à chaud entre contacts électriques mâles et femelle liée à un problème de fabrication, de maintenance ou encore de conséquences liées au vieillissement imposé par les exigences aéronautiques. Les vibrations mécaniques, les cycles thermiques en lien avec les phases de vol (variation d'altitude) peuvent être à l'origine par exemple de la corrosion de contacts électriques encore appelée fretting-corrosion, évènement précurseur de l'apparition d'un arc série 4. Contrairement à l'arc parallèle 2, l'arc série 4 est extrêmement difficile à diagnostiquer sur les mesures de courant. Au mieux, il génère une petite inflexion de courant restant généralement dans les gabarits de fonctionnement nominal des charges électriques 6. Des algorithmes plus complexes sont étudiés pour la détection de l'arc série 4 en ajoutant des couches de traitement de signal, mais la grande variabilité des charges et les contraintes environnementales les rendent peu robustes.

En aéronautique, tout est fait pour d'une part limiter au maximum l'apparition de ces phénomènes et d'autre part en limiter les conséquences lorsqu'ils apparaissent. Dans les aéronefs actuels, une stratégie d'ensemble a été déployée pour y parvenir. On peut notamment citer les mesures suivantes.

Une limitation de la tension AC distribuée à 230/400 volts. Ces faibles niveaux de tension sont les grandeurs proposées sur les minimums des courbes de Paschen. Cela permet d'empêcher toute possibilité d'amorcer un arc par surtension, y compris en haute altitude pour les équipements placés en zones dépressurisées. Cela permet également de limiter l'expansion de l'arc électrique dont le champ électrique ne peut dépasser la tension du réseau.

Une distribution d'une tension de forme d'onde alternative favorise l'auto-extinction de l'arc électrique à chaque demi-période.

Compte tenu de la problématique de maintien de l'arc sur des formes d'ondes de courant DC, les réseaux continus distribués sont à très basse tension, typiquement 28 volts.

Les règles de conception et de routage des harnais sont adaptées en tenant compte de l'impact de l'arc dans son environnement.

Enfin, des dispositifs de diagnostic de ligne par mesure de courant permettent de détecter la majorité des arcs parallèles. Ces dispositifs sont couplés à des systèmes de coupure afin d'isoler et protéger une ligne impactée par un défaut d'arc, entre autres.

Cette solide stratégie de mitigation est ce qui a permis de ne pas rendre obligatoire une détection de défauts d'arcs électriques sur les réseaux de distribution électrique à bord des aéronefs actuels.

Les études faites dans le cadre de la montée en puissance pour les réseaux propulsifs et non propulsifs, démontrent la nécessité de disposer de réseaux de distribution électrique plus haute tension et éventuellement d'une distribution en tension continue DC. De tels changements pourraient augmenter le risque d'apparition d'arcs de défaut et aggraver les dommages associés. La densification du câblage liée à l'augmentation du nombre d'équipements embarqués et la complexité de ces équipements sont des facteurs aggravants. La stratégie d'ensemble de mitigation doit ainsi être réévaluée et la détection d'arcs électriques de défaut à bord des aéronefs est une des solutions qui pourraient s'imposer.

Des techniques de détection d'arcs électriques de défaut sont connues, basées sur une mesure optique des variations de lumière générées par un arc électrique de défaut, par le déploiement d'une fibre optique couplée à un récepteur de mesure et analyse de spectre lumineux. La gaine protectrice externe de fibre optique qui protège mécaniquement le cœur de fibre doit nécessairement être translucide pour permettre de capter ces variations optiques issues des arcs électriques de défaut. En conséquence, un inconvénient de cette mesure optique, est de déployer une fibre optique dont les pertes en ligne seront de fait très importantes.

Le document FR 3 056 966 A1 divulgue un procédé pour détecter, localiser et identifier des arcs électriques dans une ligne électrique d'un aéronef.

La présente invention a pour objet de proposer une solution technique fiable et robuste au problème posé par la détection des arcs électriques de défaut pouvant apparaître dans un harnais électrique d'aéronef. Plus particulièrement, la présente invention a pour objet de proposer une solution de diagnostic fiable et robuste de défauts d'arcs électriques parallèles et séries pouvant apparaître localement au sein des interfaces électriques de ces harnais.

Il est difficile de concevoir un système fiable et robuste de détection d'arcs électriques de défaut. Il faut tenir compte de la grande variété de charges électriques susceptibles d'être embarquées, certaines pouvant avoir des signatures proches de celles d'un arc électrique de défaut. Les contraintes environnementales imposées en aéronautique, notamment les contraintes électromagnétiques, peuvent impacter la robustesse de certains systèmes de mesure, comme par exemple, ceux basés sur des mesures courant/tension.

La présente invention a pour objet de remédier à ces différents problèmes techniques en proposant une solution technique simple et peu coûteuse à mettre en œuvre, et dont la fiabilité et la robustesse sont élevées.

### Résumé

La présente invention concerne un réseau de distribution électrique d'aéronef comportant un harnais de câbles électriques formant une route de distribution électrique entre une source et au moins une charge, ledit harnais comprenant au moins un tronçon connecté en série entre la source et la ou les charges par au moins un organe d'interface de connexion,
caractérisé en ce qu'il comprend un dispositif de diagnostic et de détection d'un défaut de type arc électrique se produisant dans ladite route de distribution électrique, ledit dispositif de diagnostic et de détection étant agencé au niveau des organes d'interfaces de connexion;
le dispositif de diagnostic et de détection comprenant :
   - une fibre optique déployée sur l'étendue d'au moins une portion de ladite route de distribution et comportant au moins un réseau de Bragg positionné au niveau de chaque organe d'interface de connexion, permettant d'associer à chaque organe d'interface de connexion une longueur d'onde caractéristique de référence du réseau de Bragg respectif, la fibre optique présentant une signature spectrale de référence comprenant lesdites longueurs d'onde caractéristiques desdits réseaux de Bragg,
   - un réflectomètre optique couplé à une extrémité amont de la fibre optique et configuré pour émettre un signal optique de référence, ledit signal optique de référence étant composé d'un spectre lumineux incident incluant la longueur d'onde caractéristique de chaque réseau de Bragg de la fibre optique, et recevoir un signal optique réfléchi composé d'un spectre lumineux réfléchi par la fibre optique définissant une signature spectrale courante de la fibre optique,
   - une unité centrale d'acquisition configurée pour détecter et localiser un ou des défauts d'arcs électriques sur un ou des organes d'interface de connexion sur la base d'une comparaison de la signature spectrale courante à une signature spectrale de référence de la fibre optique.

Un arc électrique provoque une augmentation locale de température. Si celui-ci apparaît au niveau de l'organe d'interface de connexion, l'environnement proche de cet organe d'interface de connexion sera soumis à une élévation de température durant la durée du défaut. L'indice de réfraction du réseau de Bragg associé en est affecté, ce qui se traduit par une modification du spectre lumineux réfléchi et reçu par le réflectomètre optique. De manière connue, les motifs de couches de silice constituant un réseau de Bragg se dilatent sous l'effet d'une augmentation de température, ce qui provoque une modification de l'indice de réfraction et donc de la longueur d'onde qui sera réfléchie par ce réseau de Bragg. Ainsi, la comparaison de la signature spectrale courante à une signature spectrale de référence permet de détecter et localiser des défauts, y compris intermittents comme peuvent l'être les arcs électriques de défaut pouvant apparaître au sein d'une route de distribution électrique d'un aéronef.

Un tel dispositif de diagnostic et de détection pour la surveillance des réseaux électriques d'aéronef basée sur la variation de la signature spectrale de la fibre optique à réseaux de Bragg est insensible aux diverses perturbations liées à l'environnement aéronautique, et notamment aux perturbations électromagnétiques et lumineuses, aux variations lentes de température et aux vibrations et chocs mécaniques, ce qui en fait un dispositif fiable et robuste.

Le dispositif de détection selon l'invention permet de localiser précisément le défaut d'arc électrique par l'association d'un réseau de Bragg à chaque organe d'interface de connexion à surveiller. On bénéficie avantageusement de la vitesse très élevée de transmission du signal par la fibre optique.

L'au moins un réseau de Bragg peut être agencé jusqu'à une distance de 10 cm de l'organe d'interface électrique. En effet, la plage de distance entre l'organe d'interface électrique et le réseau de Bragg correspondant peut s'étendre jusqu'à une dizaine de centimètres sans perte d'efficacité de la détection.

La plage de distance peut être adaptée en pratique pour optimiser les critères de fiabilité et de robustesse, en fonction des organes d'interface électriques concernés et des types et caractéristiques (énergie, plasma) des défauts d'arc électrique qui peuvent y apparaitre.

Le dispositif de diagnostic et de détection peut être apte à actionner un dispositif de coupure configuré pour isoler ladite route de distribution électrique du reste du réseau de distribution électrique, et l'unité centrale d'acquisition peut être configurée pour envoyer un signal de détection d'un défaut d'arc électrique localisé au niveau de l'organe d'interface de connexion associé au dispositif de coupure pour actionner le dispositif de coupure.

Une telle caractéristique permet une isolation rapide et automatique de la route de distribution et évite ainsi toute propagation ou aggravation du défaut.

Le réflectomètre peut être configuré pour, avant une alimentation de la route de distribution, émettre le signal optique de référence et recevoir un signal optique réfléchi composé d'un spectre lumineux réfléchi par la fibre optique, ledit spectre lumineux réfléchi définissant la signature spectrale de référence de la fibre optique.

Une telle caractéristique permet d'acquérir une nouvelle signature spectrale de la fibre à chaque mise en route et ainsi de tenir compte de variations d'état de la route de distribution.

Le réflectomètre peut être configuré pour émettre le signal optique de référence et recevoir le signal optique réfléchi définissant la signature spectrale courante de la fibre optique de manière continue, pendant une alimentation de la route de distribution.

Une telle caractéristique permet un fonctionnement constant du système de détection, permettant une réaction plus rapide.

L'unité centrale d'acquisition peut être configurée pour comparer la signature spectrale courante et la signature spectrale de référence de la fibre optique par détection d'un décalage entre l'une des longueurs d'onde caractéristiques d'un des réseaux de Bragg dans la signature spectrale courante et dans la signature spectrale de référence de la fibre optique.

Une telle caractéristique permet de comparer de manière simple et robuste la signature spectrale courante et la signature spectrale de référence.

Les caractéristiques de la gaine mécanique de protection externe du cœur de fibre sont telles que le spectre lumineux reste contenu à l'intérieur du cœur de la fibre, pour permettre la détection et la classification de toutes variations du spectre lumineux réfléchi. Cela permet avantageusement d'avoir peu de pertes en ligne.

Le dispositif de détection à fibre optique à réseaux de Bragg proposé dans l'invention permet une détection de défaut d'arc fiable et rapide qui permet d'activer le cas échéant un dispositif de coupure permettant de stopper rapidement la propagation de l'arc électrique et d'en limiter les conséquences.

Le spectre de référence ou la signature spectrale de référence, correspondent à un état de fonctionnement normal du réseau de distribution électrique, c'est-à-dire dire un fonctionnement en l'absence de dysfonctionnement tel qu'un défaut d'arc électrique parallèle ou d'arc électrique série.

Le signal de détection selon l'invention permet d'activer le dispositif de coupure de la route concernée par le défaut. A l'inverse si le fonctionnement du réseau de distribution électrique est normal, le dispositif de coupure n'est pas activé et le réseau de distribution électrique continue à fonctionner.

La fibre à réseaux de Bragg est configurée de sorte que chaque réseau de Bragg est localisé dans ou à proximité de l'organe d'interface électrique associé.

L'invention concerne également un procédé de détection d'arc électrique série mettant en œuvre un dispositif comme plus haut dans un réseau de distribution électrique d'aéronef, le procédé comprenant les étapes suivantes :
- émission d'un signal optique de référence, ledit signal optique de référence étant composé d'un spectre lumineux incident incluant la longueur d'onde caractéristique de chaque réseau de Bragg de la fibre optique, et réception en continu d'un signal optique réfléchi composé d'un spectre lumineux réfléchi par la fibre optique définissant une signature spectrale courante de la fibre optique,
- comparaison de ladite signature spectrale courante à une signature spectrale de référence de référence grâce à l'unité centrale d'acquisition et détection et localisation d'un éventuel défaut d'arc électrique.

Le procédé peut comprendre en outre l'étape suivante :
- en cas de détection d'un défaut d'arc électrique au niveau d'un organe d'interface de connexion, envoi d'un signal de détection d'un défaut d'arc électrique localisé au niveau de l'organe d'interface de connexion en question à un dispositif de coupure pour actionner ledit dispositif de coupure.

Une telle caractéristique permet une isolation rapide et automatique de la route de distribution et évite ainsi toute propagation ou aggravation du défaut.

Le procédé peut comprendre en outre les étapes suivantes :
- avant une alimentation de la route de distribution, émission d'un signal optique de référence, et réception d'un signal optique réfléchi composé d'un spectre lumineux réfléchi par la fibre optique et définissant la signature spectrale de référence de la fibre optique, et
- mémorisation, dans l'unité centrale d'acquisition, de la signature spectrale de référence.

Une telle caractéristique permet d'acquérir une nouvelle signature spectrale de la fibre à chaque mise en route et ainsi de tenir compte de variations d'état de la route de distribution.

Les étapes d'émission du signal optique de référence et de comparaison de la signature spectrale courante et de la signature spectrale de référence peuvent être mises en œuvre de manière continue pendant une alimentation de la route de distribution.

Une telle caractéristique permet un fonctionnement constant du système de détection, permettant une réaction plus rapide.

La détection d'un éventuel défaut d'arc électrique peut être faite par comparaison de la signature spectrale courante et de la signature spectrale de référence, par mesure d'un décalage d'au moins une longueur d'onde caractéristique d'un des réseaux de Bragg.

Une telle caractéristique permet de comparer de manière simple et robuste la signature spectrale courante et la signature spectrale de référence.

L'étape de comparaison de la signature spectrale peut comprendre la mise en œuvre d'un algorithme de ségrégation, propre à ségréguer un changement de température consécutif à un défaut d'arc électrique d'un changement de température consécutif à une cause extérieure.

Une telle caractéristique permet de réduire les cas de faux positifs dans la détection d'arcs électriques dus à des changements de températures externes.

L'invention concerne en outre un aéronef comprenant un réseau de distribution comme plus haut.

### Brève description des dessins

D'autres caractéristiques, détails et avantages apparaîtront à la lecture de la description détaillée ci-après, et à l'analyse des dessins annexés, sur lesquels :
La figure 1 montre un circuit électrique comportant un arc électrique parallèle.
La figure 2 montre un circuit électrique comportant un arc électrique série.
La figure 3 montre un harnais comprenant des câbles électriques et une fibre optique maintenus ensemble par un support.
La figure 4 montre une vue en coupe de la figure 3.
La figure 5 montre une fibre optique à réseaux de Bragg, ladite fibre optique comportant trois réseaux de Bragg.
La figure 6 montre une répartition de température lors d'une formation d'un arc électrique.
La figure 7 montre un exemple de spectre incident émis par un réflectomètre optique à l'extrémité amont de la fibre optique de la figure 5,
La figure 8 montre le spectre transmis à l'extrémité aval de cette fibre optique, et
La figure 9 montre le spectre réfléchi et revenant vers l'extrémité amont de cette fibre optique.
La figure 10 montre un système de harnais connecté à une source, des organes d'interfaces de connexions électriques aval, intermédiaires et amont et comprenant un système de détection selon l'invention à réflectomètre optique couplé à une fibre optique à réseaux de Bragg déployée le long du harnais.
La figure 11 montre un mode de réalisation où la fibre optique s'étend à l'intérieur d'un connecteur modulaire.
La figure 12 montre, à gauche, le spectre réfléchi par une fibre à réseaux de Bragg d'un système de détection selon l'invention correspondant à un fonctionnement normal et à droite, un spectre réfléchi par cette même fibre lors de l'apparition d'un défaut d'arc électrique.

### Description des modes de réalisation

L'apparition d'un arc électrique est un phénomène redouté en aéronautique. L'évolution vers des aéronefs toujours plus électriques oblige à un changement de paradigme pour la gestion des risques induits par des arcs électriques de défaut sur les réseaux de distribution électrique embarqués. Si leur détection devient une composante essentielle de la stratégie de mitigation d'ensemble pour la gestion de ces risques, cela doit se faire avec l'assurance que les critères de fiabilité et de robustesse de cette détection soient au plus proche des 100% pour des raisons de sécurité et de qualité et pour ne pas compromettre les autres choix technologiques définis dans cette stratégie d'ensemble de mitigation.

Le critère de fiabilité correspond à la capacité à détecter, de préférence rapidement, tous les arcs électriques de défaut indépendamment de leur énergie, leur caractère erratique ou de la variabilité de leurs signatures au sein de l'architecture électrique concernée. En d'autres termes, la fiabilité est le critère de réussite assurant la vraie détection. Plus il est élevé, plus le système est fiable.

Le critère de robustesse du système de détection d'arcs électriques de défaut évalue sa capacité à ne détecter que ce type de défaut et à ségréguer toutes autres signatures. En d'autres termes, la robustesse est le critère assurant la non-détection de faux positifs. Il est lié au niveau de bruit mesuré et représente ainsi la faculté d'un dispositif à résister aux variations environnementales, par exemple. Les variations environnementales sont assez importantes pour l'aéronef : variation de pression, de température et d'humidité. Les systèmes installés sur aéronefs doivent, en outre, subir une pluralité d'essais électromagnétiques pour pouvoir être qualifiés et certifiés. Les capteurs installés sur l'avion étant soumis à rude épreuve, ces capteurs ne doivent pas se déclencher de manière intempestive.

Dans l'invention, on propose un dispositif de détection de défaut d'arc électrique pour harnais d'un réseau de distribution électrique d'aéronef qui présente ces qualités.

L'arc électrique induit de nombreuses perturbations physiques dans son environnement. Parmi elles, les phénomènes physiques proches des électrodes et au sein de la colonne d'arc sont à l'origine de l'émission d'intenses spectres lumineux ainsi que des émanations de matériaux liquéfiés ou vaporisés. Également, l'arc électrique engendre des émissions radio fréquence et une modification locale de la température du gaz dans lequel il intervient. Dans l'invention, c'est l'impact de l'arc sur la température locale de l'environnement gazeux qui est exploité dans le système de détection de défaut d'arc électrique selon l'invention, en utilisant une fibre optique à réseaux de Bragg judicieusement positionnés pour que chacun soit situé à proximité d'un organe d'interface électrique du harnais à surveiller, couplée à un réflectomètre permettant de suivre les variations de spectre optique induites par de brusques variations de température dans l'environnement des réseaux de Bragg.

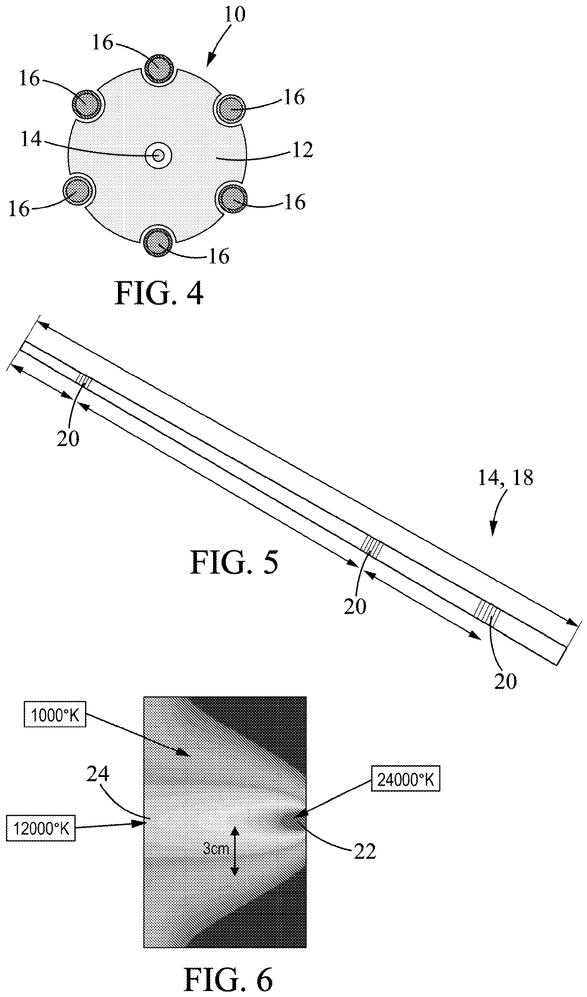

Le système de détection selon l'invention est plus particulièrement décrit en prenant en exemple, illustré sur les figures 3 et 4, un tronçon d'un harnais d'un réseau de distribution électrique 10, installé avec un support 12, aussi appelé bobine de ségrégation. Le support 12 est conçu pour jouer un rôle de maintien et de ségrégation entre les câbles électriques du harnais et notamment, limiter ainsi les risques d'apparition et de propagation d'arcs électriques et de leurs dommages associés. De tels supports sont notamment utilisés pour la distribution de forte puissance, impliquant des câbles électriques 16 dimensionnés pour supporter de forts courants.

De manière connue, le harnais dispose en amont, c'est-à-dire côté source, d'un dispositif de coupure, dont la fonction est d'ouvrir ou fermer les lignes électriques des câbles composant le harnais à partir d'une commande. Cette commande provient souvent d'un système de protection ou encore correspond à une sollicitation extérieure, par exemple en cas de reconfiguration des charges.

Selon un mode de réalisation de l'invention appliquée à une telle installation, une fibre optique 14 à réseau(x) de Bragg est montée au centre du faisceau des câbles électriques 16, et déployée sur la longueur du tronçon, autrement dit aux côtés des câbles électriques 16. La fibre optique 14 est couplée à une extrémité amont à un réflectomètre optique. Le réflectomètre optique fait partie d'un système de diagnostic et de détection configuré pour détecter et réagir à la formation d'un arc électrique dans le harnais de câbles. Le système de diagnostic et de détection, comprenant le réflectomètre, est positionné du même côté et à proximité d'un système de coupure, en charge de la protection et l'ouverture ou fermeture de chaque câble électrique 16 composant le harnais. Cette proximité permet d'assurer une communication fiable et simple à mettre en œuvre du système de diagnostic vers le système de coupure, pour transmettre un ordre de coupure, le cas échéant.

De manière connue, le réflectomètre émet un signal optique incident à l'entrée de la fibre optique 14 et reçoit en retour un signal optique réfléchi, dont le spectre est constitué des raies lumineuses correspondant aux longueurs d'onde caractéristiques réfléchies par les réseaux de Bragg 20. C'est la signature spectrale courante de la fibre à réseaux de Bragg qui reflète l'état de réseaux de Bragg 20 présents dans ladite fibre optique 14.

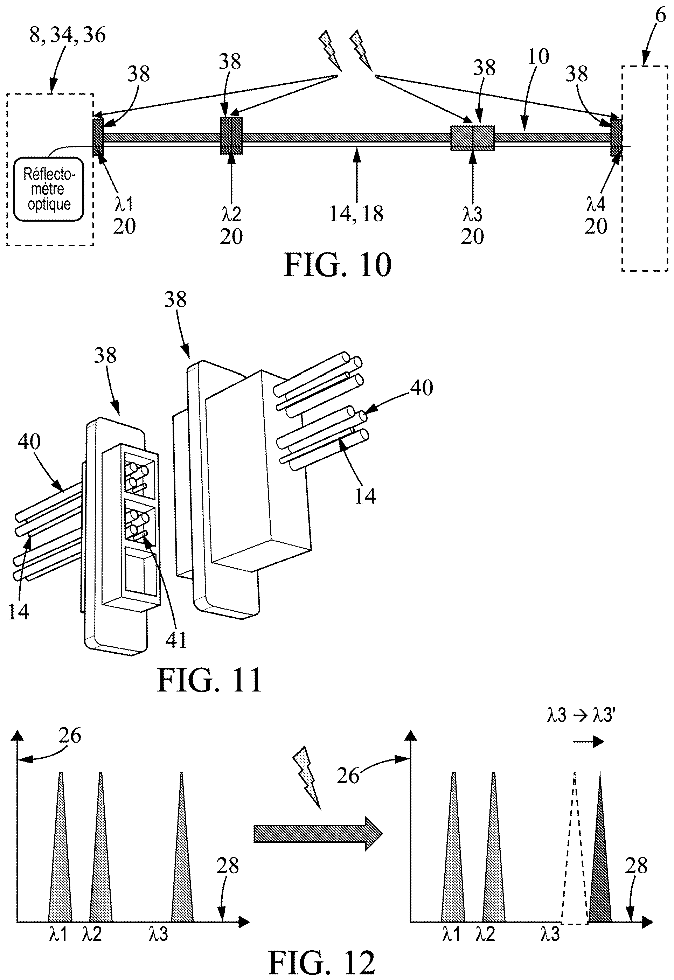

Il est ainsi possible de détecter efficacement les arcs électriques parallèles 2 ou séries 4 qui apparaissent au niveau d'organes d'interfaces de connexion 38 d'une route de distribution électrique intégrant une telle fibre optique 14, comme représentée sur la figure 10. A chacun de ces organes d'interface de connexion 38 est associé un réseau de Bragg 20 respectif, ayant une longueur d'onde caractéristique λ₁, λ₂, λ₃, λ₄ propre (ou, de manière équivalente, un indice de réfraction propre). Autrement dit, au sein d'un même harnais, chacun des réseaux de Bragg 20 intégrés dans la fibre optique 14 est localisé au niveau d'un organe d'interface de connexion 38 et a un indice de réfraction propre différent des autres.

Dans l'exemple illustré en figures 3 et 4, le tronçon de harnais électrique 10 utilise des supports 12 de type bobines de ségrégation des câbles 16, qui maintiennent les câbles électriques à distance les uns des autres et les maintiennent au sein de la structure de l'aéronef. On peut alors avantageusement placer la fibre optique 14 au centre du faisceau de câbles électrique et la faire passer par un trou central ménagé au centre des bobines de ségrégation.

Mais l'invention est applicable à toute configuration de harnais, ségrégué ou non. Par exemple, la fibre optique 14 peut-être torsadée autour d'un harnais composé de câbles électriques non ségrégués de sorte à rester dans un environnement proche du réseau de distribution électrique à surveiller.

Comme illustré en figure 5, la fibre optique 14 déployée comprend les réseaux de Bragg 20 espacés le long d'une partie 18 s'étendant avec les câbles 16.

De manière connue, une fibre à réseaux de Bragg ou FBG (Fiber Bragg Gratting en anglais) est une fibre monomode, constituée localement de successions de plusieurs couches à base de silice dont les épaisseurs varient d'une couche à l'autre, provoquant des variations locales de l'indice de réfraction. La fibre optique 14 comprend ainsi une série de réseaux de Bragg 20 au long de la fibre.

Dans une telle fibre à réseaux de Bragg, il est possible de calibrer, lors de la conception :
- un nombre de réseaux de Bragg 20 chacun caractérisé par une longueur d'onde caractéristique propre, correspondant à une alternance particulière d'indices de réfraction du cœur de la silice de la fibre optique,
- la position de chacun de ces réseaux de Bragg 20 dans la fibre.

En pratique, et en fonction des caractéristiques du ou des harnais à protéger, on définit alors :
- une longueur de la fibre optique 14 associée à la longueur du harnais à protéger ; et
- pour chaque position d'un organe d'interface de connexion 38 le long du harnais à protéger, une position d'un réseau de Bragg 20 associé au sein de la fibre optique 14.

On peut utiliser pour cela une maquette digitale, qui est une représentation tridimensionnelle de l'avion et des harnais, encore appelée « Digital Mock-Up » (DMU) en anglais, ou toute autre spécification équivalente pour définir les règles de fabrication de la fibre optique à réseaux de Bragg selon l'invention pour chaque harnais que l'on souhaite protéger sur tout ou partie de sa longueur. L'objectif ici est de fabriquer une fibre optique 14 à réseaux de Bragg pour que, une fois déployée le long de tout ou partie du harnais, les réseaux de Bragg 20 coïncident localement avec les organes d'interface de connexion 38 à surveiller. Les organes d'interface de connexion 38 à surveiller comprennent ceux qui relient deux tronçons entre eux et ou un tronçon à la source ou à une charge. Ces organes d'interface de connexion 38 sont ceux identifiés comme les interfaces électriques amont, aval et intermédiaire(s) dans l'art antérieur.

S'agissant de la distance entre le harnais 10 et la fibre optique 14, elle résulte d'un compromis : elle doit permettre une détection fiable d'une augmentation locale de température par le réseau de Bragg 20 respectif de la fibre 14 mais prendre en compte les contraintes pratiques de son installation.

Un endommagement partiel ou complet de la fibre optique à réseaux de Bragg par l'échauffement de température d'un arc de défaut ou son interaction directe avec le plasma est une possibilité. Néanmoins, cette défaillance sera précédée d'un diagnostic de présence d'un arc électrique du système de diagnostic couplé au réflectomètre qui aura donné l'ordre de coupure au système de coupure. Dans un second temps, en phase de maintenance associée aux réparations nécessaires à l'apparition de l'arc avant sa coupure, une inspection devra être faite également sur la fibre optique afin de proposer une réparation si nécessaire.

On peut montrer qu'un agencement de la fibre optique à une distance inférieure à 10 cm d'un câble du harnais permet de capter rapidement les brusques variations de températures liées à la création du défaut. Selon les types de connecteurs ou de borniers sujets à de potentiels arcs électriques, l'homme du métier sera en mesure d'affiner cette distance en tenant compte de la potentielle énergie dissipée par l'arc et de sa potentielle expansion.

La figure 6 illustre un exemple de gradient de température d'un arc électrique se produisant entre une cathode 22 à droite et une anode 24 à gauche. L'illustration permet de comprendre que l'apparition d'un arc électrique génère une très forte évolution de température dans l'environnement proche. Un gradient de température est systématique entre le gaz ambiant et le centre de la colonne d'arc, parfois sur plusieurs centimètres. La fibre optique à réseaux de Bragg est capable de mesurer des variations brutales de températures d'amplitudes très basses (jusqu'à une variation d'un degré Celsius) en comparaison des variations observées sur cette illustration. L'association d'une fibre optique à réseaux de Bragg et d'un algorithme de discrimination est donc pertinente.

En effet, en aéronautique, il n'est pas rare d'observer des variations de température. La localisation de l'aéronef sur différents endroits de la planète, les cycles de vols et l'échauffement local provoqué par d'autres équipements sont autant de facteurs extérieurs pouvant aboutir à des variations plus ou moins lentes de températures. L'ensemble des équipements installés sur avion doivent être robustes face à ces variations. Le présent dispositif comporte donc un algorithme capable de dissocier ces variations environnementales des signatures thermiques générées par des arcs électriques.

Comme défini, la fibre optique 14 à réseaux de Bragg est couplée à une extrémité amont à un réflectomètre. Un signal optique incident présentant un spectre lumineux incident est émis par ledit réflectomètre avec une large bande spectrale définie au préalable pour englober les raies correspondantes aux longueurs d'ondes caractéristiques propres des réseaux de Bragg 20 de la fibre optique 14. De manière connue, une partie de ce flux lumineux est réfléchie par les réseaux de Bragg 20 vers le réflectomètre, qui correspond à la signature spectrale de la fibre 14 : il contient l'ensemble des raies correspondant aux longueurs d'ondes réfléchies par tous les réseaux de Bragg 20 disposés sur ladite fibre optique.

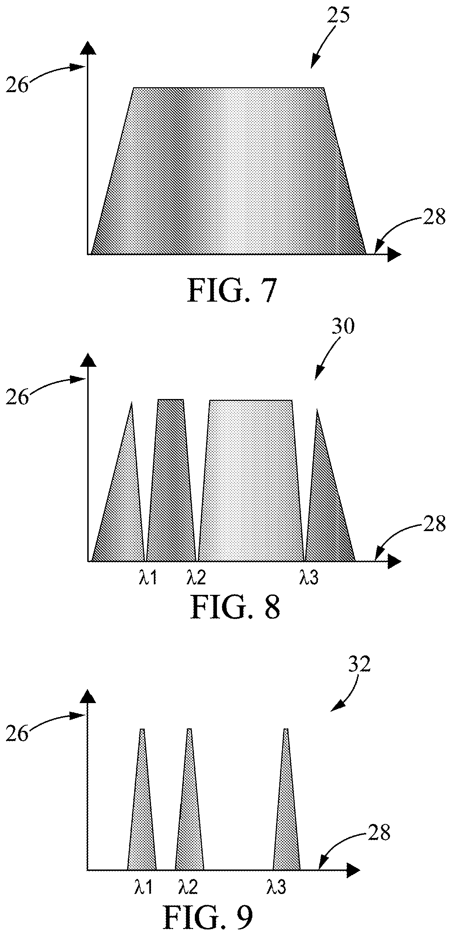

Les figures 7 à 9 représentent les spectres lumineux respectivement émis, transmis et réfléchi par une fibre optique 14 à réseaux de Bragg 20 telle que celle représentée en figure 5, avec selon l'axe des ordonnées, l'intensité 26 et selon l'axe des abscisses, les longueurs d'onde 28. La figure 7 représente un spectre lumineux incident 25, émis par réflectomètre sur une extrémité amont de la fibre optique 14. La figure 8 illustre le spectre lumineux transmis 30, obtenu à l'autre extrémité (aval) de la fibre optique 14. La figure 9 illustre le spectre lumineux réfléchi 32 par la fibre optique 14, revenant vers le réflectomètre.

Dans l'exemple représenté, la fibre optique 14 comporte trois réseaux de Bragg 20, tels qu'identifiés sur la figure 5, avec trois indices de réfraction différents, définissant trois longueurs d'onde caractéristiques propres à chaque réseau de Bragg 20, respectivement λ₁, λ₂ et λ₃. En se propageant au travers de ladite fibre optique 14 et au travers de chaque réseau de Bragg 20, il en résulte que les longueurs d'onde λ₁, λ₂ et λ₃, ne sont pas transmises vers l'autre extrémité de fibre, comme illustré en figure 8, mais réfléchies vers le réflectomètre, comme illustré sur la figure 9. Autrement dit, le spectre lumineux réfléchi comprend uniquement trois raies d'émissions correspondant à ces trois longueurs d'onde λ₁, λ₂ et λ₃.

La figure 10 illustre un réseau de distribution 10 comprenant une route de distribution composée de trois tronçons de câbles électriques 16 interconnectés par des organes d'interface de connexion électriques 38. En amont de la route de distribution, une source 8 représente soit une source d'alimentation, soit un meuble de distribution électrique tel qu'il a été précédemment expliqué dans la présentation de l'art antérieur. Dans les deux cas, cet équipement a pour rôle de fournir une alimentation à la route de distribution jusqu'à une charge 6 en aval. La source 8 amont et la charge 6 aval sont également connectées à la route de distribution via des organes d'interface de connexion électrique 38 associés. La route de distribution est associée à un dispositif de diagnostic et de détection d'arc électrique comprenant une fibre optique 14 à réseaux de Bragg 20. Dans cet exemple, la fibre optique 14 se déploie tout au long de la route de distribution entre la source 8 et la charge 6. Le système de diagnostic et de détection est composé de la fibre 14 à réseaux de Bragg 20 et d'une unité centrale d'acquisition 34 associée au réflectomètre optique 36. Ces éléments sont également positionnés en amont de la route de distribution. Le réflectomètre optique 36 est couplé à l'extrémité de la fibre optique 14 du côté amont, c'est-à-dire du côté de la source 8.

Dans cet exemple, la fibre optique à réseaux de Bragg comporte quatre réseaux de Bragg 20 en vue de correspondre aux quatre organes d'interfaces de connexions électriques 38. Les arcs électriques séries 4 se produisent spécifiquement au niveau des organes d'interface de connexion électrique 38, qui sont donc des zones sensibles à protéger.

Un emplacement peut être dédié dans chaque organe d'interface de connexion électrique 38 pour accueillir la fibre optique 14 à l'intérieur de l'organe d'interface de connexion électrique 38, ou bien la fibre optique 14 peut s'étendre à côté de l'organe d'interface de connexion électrique 38.

La figure 11 illustre un exemple pratique d'utilisation d'un organe d'interface de connexion 38, qui est un connecteur de type multi modulaire pour accueillir des fibres optiques 14 selon l'invention. Un tel connecteur comprend de manière connue plusieurs modules ou logements, trois dans l'exemple représenté, qui peuvent chacun accueillir et interconnecter des câbles. Dans l'exemple, deux modules sont utilisés, qui accueillent chacun trois câbles de puissance 40 et une fibre optique 14. Un troisième module n'est pas pourvu. Les câbles 40 sont interconnectés de manière connue dans l'organe d'interface de connexion 38 via des contacts électriques mâles et femelles. De manière similaire, on prévoit un couplage par connectique optique 41 pour interconnecter les deux parties de la fibre optique 14. Chacune des deux parties de fibres sera en pratique conçue pour qu'après montage, le réseau de Bragg 20 associé à ce connecteur 38 soit à proximité de la connectique optique 41 respective, de préférence à une distance inférieure à deux centimètres de cette connectique optique 41.

Dans un exemple pratique, on sait disposer jusqu'à vingt réseaux de Bragg 20 dans la fibre optique 14, ce qui convient bien pour la détection d'arcs électriques série dans des harnais d'aéronef, car le nombre de tronçons et donc d'organes d'interfaces de connexions intermédiaires 38 est très globalement inférieur à la dizaine.

La calibration des réseaux de Bragg 20 est choisie de sorte à obtenir une bonne répartition des longueurs d'onde caractéristiques propres sur l'étendue du spectre lumineux émis par le réflectomètre. On comprend que cela facilite la détection d'une variation de longueur d'onde caractéristique et l'identification du réseau de Bragg correspondant, et donc la localisation de l'organe d'interface de connexion affecté par un ou des arcs électriques séries ou parallèles.

Le diagnostic est initié par une étape d'initialisation, pour obtenir la signature spectrale de référence. Cette étape d'initialisation peut être réalisée pour chaque vol avant la mise sous tension de la route de distribution, par exemple. Au cours de cette phase d'initialisation, le réflectomètre optique 36 émet un spectre incident sur la fibre optique 14 à réseaux de Bragg, et réceptionne un spectre réfléchi 32 correspondant. Ce spectre réfléchi 32 devient le spectre de référence caractérisant la route de distribution dans son fonctionnement normal tel qu'il a été défini précédemment.

A la mise sous tension de la route de distribution, le diagnostic opérationnel peut débuter. Le réflectomètre optique 36 émet alors de manière continue un spectre incident sur l'extrémité amont de la fibre optique 14 à réseaux de Bragg, qui est le même spectre que celui émis lors de la phase d'initialisation. Également de manière continue, le réflectomètre optique 36 réceptionne, sur cette même extrémité amont, le spectre réfléchi, que l'on appelle dans la suite la signature spectrale courante, c'est à dire représentatif de l'état du moment, donc "courant", de la route de distribution qui est surveillée.

Toujours de manière continue, le système de diagnostic composé d'une centrale d'acquisition 34 met en œuvre un algorithme de comparaison de la signature spectrale courante à la signature spectrale de référence. A l'issue de cette comparaison, l'algorithme mis en œuvre par la centrale d'acquisition 34 détermine si la route de distribution électrique est impactée ou non par un arc électrique.

L'algorithme est avantageusement propre à ségréguer les variations de température (qui entrainent un décalage d'au moins une des longueurs d'onde caractéristiques dans la signature spectrale courante) consécutives à la formation d'un défaut d'arc électrique au niveau d'un organe de connexion 38, des variations de températures consécutives à d'autres phénomènes externes. Un tel algorithme peut par exemple se baser sur la rapidité de la variation de température, qui est très élevée pour un défaut d'arc électrique.

La figure 12 illustre, à gauche, le spectre lumineux réfléchi de référence 32 issu de l'étape d'initialisation. A droite, il s'agit d'un spectre lumineux réfléchi, correspondant à la signature spectrale courante, obtenu, dans le cas où un défaut d'arc électrique est apparu entre deux contacts électriques dans l'organe d'interface de connexion électrique 38. On peut ainsi voir que l'élévation de température induite par cet arc électrique se traduit par une variation de la longueur d'onde caractéristique du réseau de Bragg placé à proximité (qui lui est appairé). Dans le présent exemple, c'est la raie correspondante à la longueur d'onde λ₃ qui est décalée vers la droite, correspondant à une longueur d'onde modifiée d'onde λ'₃, ce qui permet d'identifier le réseau de Bragg 20 concerné et donc l'organe d'interface de connexion 38 qui lui est appairé. Selon l'exemple de la figure 12, le diagnostic opérationnel détecte et localise donc l'apparition d'un arc électrique au sein du troisième connecteur du harnais concerné.

En cas de diagnostic positif au cours de l'étape de diagnostic opérationnel, le dispositif de diagnostic et de détection envoie un ordre de commande d'ouverture de ligne vers le système de coupure associé à la route de distribution impactée par le défaut d'arc électrique, afin d'isoler au moins le tronçon de la route de distribution impacté par l'arc électrique.

L'étape de diagnostic opérationnel se poursuit durant toutes les missions de l'aéronef, au sol ou en vol jusqu'à l'arrêt de l'alimentation de la route de distribution à surveiller.

La présente fibre optique 14 à réseaux de Bragg 20 associé à un tel dispositif de diagnostic permet la détection et la localisation fiable d'arc(s) électrique(s) série(s) 4 ou parallèle(s) 2 pouvant intervenir au sein d'organes d'interfaces de connexion 38 en exploitant les changements de température brutaux (l'amplitude de la variation de température pouvant être faible, de l'ordre de 1°C), à l'endroit de la survenance de l'arc électrique. Dans le cas où un arc électrique est détecté, un dispositif de coupure est actionné afin d'isoler l'ensemble de la route de distribution dont dépend l'organe d'interface de connexion électrique endommagé ainsi localisé sur le réseau de distribution électrique.

## Revendications

1. Réseau de distribution électrique (10) d'aéronef comportant un harnais de câbles électriques (40) formant une route de distribution électrique entre une source (8) et au moins une charge (6), ledit harnais comprenant au moins un tronçon connecté en série entre la source (8) et la ou les charges (6) par au moins un organe d'interface de connexion (38),
ledit réseau comportant un dispositif de diagnostic et de détection d'un défaut de type arc électrique se produisant dans ladite route de distribution électrique, ledit dispositif de diagnostic et de détection étant agencé au niveau des organes d'interfaces de connexion (38); **caractérisé en ce que**
le dispositif de diagnostic et de détection comprend :
- une fibre optique (14) déployée sur l'étendue d'au moins une portion de ladite route de distribution et comportant au moins un réseau de Bragg (20) positionné au niveau de chaque organe d'interface de connexion (38), permettant d'associer à chaque organe d'interface de connexion (38) une longueur d'onde caractéristique de référence du réseau de Bragg (20) respectif, la fibre optique (14) présentant une signature spectrale de référence comprenant lesdites longueurs d'onde caractéristiques desdits réseaux de Bragg (20),
- un réflectomètre (36) optique couplé à une extrémité amont de la fibre optique (14) et configuré pour émettre un signal optique de référence, ledit signal optique de référence étant composé d'un spectre lumineux incident incluant la longueur d'onde caractéristique de chaque réseau de Bragg (20) de la fibre optique (14), et recevoir un signal optique réfléchi composé d'un spectre lumineux réfléchi par la fibre optique (14) définissant une signature spectrale courante de la fibre optique (14),
- une unité centrale d'acquisition (34) configurée pour détecter et localiser un ou des défauts d'arcs électriques sur un ou des organes d'interface de connexion (38) sur la base d'une comparaison de la signature spectrale courante à une signature spectrale de référence de la fibre optique.

2. Dispositif selon la revendication 1, dans lequel l'au moins un réseau de Bragg (20) est agencé jusqu'à une distance de 10 cm de l'organe d'interface électrique (38).

3. Dispositif selon l'une des revendications précédentes, dans lequel le dispositif de diagnostic et de détection est apte à actionner un dispositif de coupure configuré pour isoler ladite route de distribution électrique du reste du réseau de distribution électrique (10), et dans lequel l'unité centrale d'acquisition (34) est configurée pour envoyer un signal de détection d'un défaut d'arc électrique localisé au niveau de l'organe d'interface de connexion (38) associé au dispositif de coupure pour actionner le dispositif de coupure.

4. Dispositif selon l'une des revendications précédentes, dans lequel le réflectomètre (36) est configuré pour, avant une alimentation de la route de distribution, émettre le signal optique de référence et recevoir un signal optique réfléchi composé d'un spectre lumineux réfléchi par la fibre optique (14), ledit spectre lumineux réfléchi définissant la signature spectrale de référence de la fibre optique (14).

5. Dispositif selon l'une des revendications précédentes, dans lequel le réflectomètre (36) est configuré pour émettre le signal optique de référence et recevoir le signal optique réfléchi définissant la signature spectrale courante de la fibre optique de manière continue, pendant une alimentation de la route de distribution.

6. Dispositif selon l'une des revendications précédentes, dans lequel l'unité centrale d'acquisition (34) est configurée pour comparer la signature spectrale courante et la signature spectrale de référence de la fibre optique (14) par détection d'un décalage entre l'une des longueurs d'onde caractéristiques d'un des réseaux de Bragg (20) dans la signature spectrale courante et dans la signature spectrale de référence de la fibre optique (14).

7. Procédé de détection d'arc électrique série mettant en œuvre un dispositif selon l'une des revendications précédentes dans un réseau de distribution électrique d'aéronef, le procédé **caractérisé en ce qu'**il comprend les étapes suivantes :
- émission d'un signal optique de référence, ledit signal optique de référence étant composé d'un spectre lumineux incident incluant la longueur d'onde caractéristique de chaque réseau de Bragg (20) de la fibre optique (14), et réception d'un signal optique réfléchi composé d'un spectre lumineux réfléchi par la fibre optique (14) définissant une signature spectrale courante de la fibre optique (14),
- comparaison de ladite signature spectrale courante à une signature spectrale de référence de référence grâce à l'unité centrale d'acquisition (34) et détection et localisation d'un éventuel défaut d'arc électrique.

8. Procédé selon la revendication 7, comprenant en outre l'étape suivante :
- en cas de détection d'un défaut d'arc électrique au niveau d'un organe d'interface de connexion (38), envoi d'un signal de détection d'un défaut d'arc électrique localisé au niveau de l'organe d'interface de connexion (38) en question à un dispositif de coupure pour actionner ledit dispositif de coupure.

9. Procédé selon la revendication 7 ou 8, comprenant en outre les étapes suivantes :
- avant une alimentation de la route de distribution, émission d'un signal optique de référence, et réception d'un signal optique réfléchi composé d'un spectre lumineux réfléchi par la fibre optique (14) et définissant la signature spectrale de référence de la fibre optique (14) et
- mémorisation, dans l'unité centrale d'acquisition (34), de la signature spectrale de référence.

10. Procédé selon l'une des revendications 7 à 9, dans lequel les étapes d'émission du signal optique de référence et de comparaison de la signature spectrale courante et de la signature spectrale de référence sont mises en œuvre de manière continue pendant une alimentation de la route de distribution.

11. Procédé selon l'une des revendications 7 à 10, dans lequel la détection d'un éventuel défaut d'arc électrique est faite par comparaison de la signature spectrale courante et de la signature spectrale de référence, par mesure d'un décalage d'au moins une longueur d'onde caractéristique d'un des réseaux de Bragg (20).

12. Procédé selon l'une des revendications 7 à 11, dans lequel l'étape de comparaison de la signature spectrale comprend la mise en œuvre d'un algorithme de ségrégation, propre à ségréguer un changement de température consécutif à un défaut d'arc électrique d'un changement de température consécutif à une cause extérieure.

13. Aéronef comprenant un réseau de distribution électrique (10) selon l'une des revendications 1 à 6.

## Patentansprüche

1. Stromverteilungsnetz (10) für Luftfahrzeuge, das einen elektrischen Kabelbaum (40) umfasst, der einen Stromverteilungspfad zwischen einer Quelle (8) und zumindest einer Last (6) bildet, wobei der Kabelbaum zumindest einen Abschnitt umfasst, der zwischen der Quelle (8) und der Last oder den Lasten (6) über zumindest ein Verbindungsschnittstellenelement (38) in Reihe geschaltet ist,
wobei das Netz eine Vorrichtung zur Diagnose und Erkennung eines in dem Stromverteilungspfad auftretenden Fehlerlichtbogens umfasst,
wobei die Diagnose- und Erkennungsvorrichtung im Bereich der Verbindungsschnittstellenelemente (38) angeordnet ist;
**dadurch gekennzeichnet, dass**
die Diagnose- und Erkennungsvorrichtung umfasst:
- eine optische Faser (14), die über die Erstreckung zumindest eines Abschnitts des Verteilungspfads verlegt ist und zumindest ein Bragg-Gitter (20) umfasst, das jeweils im Bereich des Verbindungsschnittstellenelements (38) positioniert ist, wodurch dem Verbindungsschnittstellenelement (38) jeweils eine charakteristische Referenzwellenlänge des jeweiligen Bragg-Gitters (20) zugeordnet werden kann, wobei die optische Faser (14) eine Referenz-Spektralsignatur aufweist, die die charakteristischen Wellenlängen der Bragg-Gitter (20) enthält,
- ein optisches Reflektometer (36), das mit einem stromaufwärtigen Ende der optischen Faser (14) gekoppelt und dazu ausgelegt ist, ein optisches Referenzsignal auszugeben, wobei das optische Referenzsignal aus einem einfallenden Lichtspektrum besteht, das die charakteristische Wellenlänge jedes Bragg-Gitters (20) der optischen Faser (14) enthält, und ein reflektiertes optisches Signal zu empfangen, das aus einem von der optischen Faser (14) reflektierten Lichtspektrum besteht, das eine aktuelle Spektralsignatur der optischen Faser (14) bestimmt,
- eine zentrale Erfassungseinheit (34), die dazu ausgelegt ist, einen oder mehrere Fehlerlichtbögen an einem oder mehreren Verbindungsschnittstellenelementen (38) auf der Grundlage eines Vergleichs der aktuellen Spektralsignatur mit einer Referenz-Spektralsignatur der optischen Faser zu erkennen und zu lokalisieren.

2. Vorrichtung nach Anspruch 1,
wobei das zumindest eine Bragg-Gitter (20) in einem Abstand von bis zu 10 cm von dem elektrischen Schnittstellenelement (38) angeordnet ist.

3. Vorrichtung nach einem der vorstehenden Ansprüche,
wobei die Diagnose- und Erkennungsvorrichtung in der Lage ist, eine Abschaltvorrichtung zu betätigen, die dazu ausgelegt ist, den genannten Stromverteilungspfad vom restlichen Stromverteilungsnetz (10) zu trennen, und wobei die zentrale Erfassungseinheit (34) dazu ausgelegt ist, ein Erkennungssignal für einen Fehlerlichtbogen, der im Bereich der zugeordneten Verbindungsschnittstelle (38) lokalisiert wurde, an die Abschaltvorrichtung zu senden, um die Abschaltvorrichtung zu betätigen.

4. Vorrichtung nach einem der vorstehenden Ansprüche,
wobei das Reflektometer (36) dazu ausgelegt ist, vor einer Einspeisung in den Verteilungspfad das optische Referenzsignal auszugeben und ein reflektiertes optisches Signal zu empfangen, das aus einem von der optischen Faser (14) reflektierten Lichtspektrum besteht, wobei das reflektierte Lichtspektrum die Referenz-Spektralsignatur der optischen Faser (14) bestimmt.

5. Vorrichtung nach einem der vorstehenden Ansprüche,
wobei das Reflektometer (36) dazu ausgelegt ist, während einer Einspeisung in den Verteilungspfad kontinuierlich das optische Referenzsignal auszugeben und das reflektierte optische Signal zu empfangen, das die aktuelle Spektralsignatur der optischen Faser bestimmt.

6. Vorrichtung nach einem der vorstehenden Ansprüche,
wobei die zentrale Erfassungseinheit (34) dazu ausgelegt ist, die aktuelle Spektralsignatur und die Referenz-Spektralsignatur der optischen Faser (14) durch Erfassen einer Verschiebung zwischen einer der charakteristischen Wellenlängen eines der Bragg-Gitter (20) in der aktuellen Spektralsignatur und in der Referenz-Spektralsignatur der optischen Faser (14) zu erfassen.

7. Verfahren zum Erkennen eines Reihen-Lichtbogens unter Verwendung einer Vorrichtung nach einem der vorstehenden Ansprüche in einem Stromverteilungsnetz eines Luftfahrzeugs,
**dadurch gekennzeichnet, dass** es die folgenden Schritte umfasst:
- Ausgeben eines optischen Referenzsignals, wobei das optische Referenzsignal aus einem einfallenden Lichtspektrum besteht, das die charakteristische Wellenlänge jedes Bragg-Gitters (20) der optischen Faser (14) enthält, und Empfangen eines reflektierten optischen Signals, das aus einem von der optischen Faser (14) reflektierten Lichtspektrum besteht, das eine aktuelle Spektralsignatur der optischen Faser (14) bestimmt,
- Vergleichen der aktuellen Spektralsignatur mit einer Referenz-Spektralsignatur durch die zentrale Erfassungseinheit (34) und Erkennen und Lokalisieren eines möglichen Fehlerlichtbogens.

8. Verfahren nach Anspruch 7,
ferner umfassend den folgenden Schritt:
- bei Erkennung eines Fehlerlichtbogens im Bereich eines Verbindungsschnittstellenelements (38) Senden eines Erkennungssignals für einen im Bereich des betreffenden Verbindungsschnittstellenelements (38) lokalisierten Fehlerlichtbogen an eine Abschaltvorrichtung, um die Abschaltvorrichtung zu betätigen.

9. Verfahren nach Anspruch 7 oder 8,
ferner umfassend die folgenden Schritte:
- vor einer Einspeisung in den Verteilungspfad, Ausgeben eines optischen Referenzsignals und Empfangen eines reflektierten optischen Signals, das aus einem von der optischen Faser (14) reflektierten Lichtspektrum besteht, das die Referenz-Spektralsignatur der optischen Faser (14) bestimmt, und
- Abspeichern der Referenz-Spektralsignatur in der zentralen Erfassungseinheit (34).

10. Verfahren nach einem der Ansprüche 7 bis 9,
wobei die Schritte des Ausgebens des optischen Referenzsignals und des Vergleichens der aktuellen Spektralsignatur mit der Referenz-Spektralsignatur während einer Einspeisung in den Verteilungspfad kontinuierlich erfolgen.

11. Verfahren nach einem der Ansprüche 7 bis 10,
wobei das Erkennen eines möglichen Fehlerlichtbogens durch Vergleichen der aktuellen Spektralsignatur mit der Referenz-Spektralsignatur erfolgt, indem eine Verschiebung von zumindest einer charakteristischen Wellenlänge eines der Bragg-Gitter (20) gemessen wird.

12. Verfahren nach einem der Ansprüche 7 bis 11,
wobei der Schritt des Vergleichens der Spektralsignatur die Anwendung eines Segregationsalgorithmus umfasst, der geeignet ist, eine Temperaturänderung infolge eines Fehlerlichtbogens von einer Temperaturänderung infolge einer externen Ursache zu unterscheiden.

13. Luftfahrzeug mit einem Stromverteilungsnetz (10) nach einem der Ansprüche 1 bis 6.

## Claims

1. Electrical power distribution network (10) of an aircraft, comprising a harness of electrical cables (40) forming an electrical distribution route between a source (8) and at least one load (6), said harness comprising at least one section connected in series between the source (8) and the load or loads (6) by at least one connection interface member (38),
said network comprising a diagnostic and detection device for diagnosing and detecting an electric arc type fault occurring in said electrical distribution route, said diagnostic and detection device being arranged at the connection interface members (38);
**characterized in that** the diagnostic and detection device comprises:
- an optical fiber (14) laid along at least a portion of said distribution route and comprising at least one Bragg grating (20) positioned at each connection interface member (38), making it possible to associate with each connection interface member (38) a characteristic reference wavelength of the respective Bragg grating (20), the optical fiber (14) having a reference spectral signature comprising said characteristic wavelengths of said Bragg gratings (20),
- an optical reflectometer (36) coupled to an upstream end of the optical fiber (14) and configured to emit a reference optical signal, said reference optical signal being composed of an incident light spectrum including the characteristic wavelength of each Bragg grating (20) of the optical fiber (14), and to receive a reflected optical signal composed of a light spectrum reflected by the optical fiber (14) which defines a current spectral signature of the optical fiber (14),
- an acquisition central processing unit (34) configured to detect and locate one or more arc faults over one or more connection interface members (38), on the basis of a comparison of the current spectral signature with a reference spectral signature of the optical fiber.

2. Device according to claim 1, wherein the at least one Bragg grating (20) is arranged at a distance of up to 10 cm from the electrical interface member (38).

3. Device according to one of the preceding claims, wherein the diagnostic and detection device is adapted to actuate a cut-off device configured to isolate said electrical distribution route from the rest of the electrical power distribution network (10), and wherein the acquisition central processing unit (34) is configured to send an arc fault detection signal for an arc fault located at the connection interface member (38) associated with the cut-off device in order to actuate the cut-off device.

4. Device according to one of the preceding claims, wherein the reflectometer (36) is configured to, before power is supplied to the distribution route, emit the reference optical signal and receive a reflected optical signal composed of a reflected light spectrum that is reflected by the optical fiber (14), said reflected light spectrum defining the reference spectral signature of the optical fiber (14).

5. Device according to one of the preceding claims, wherein the reflectometer (36) is configured to emit the reference optical signal and receive the reflected optical signal defining the current spectral signature of the optical fiber in a continuous manner, during the supply of power to the distribution route.

6. Device according to one of the preceding claims, wherein the acquisition central processing unit (34) is configured to compare the current spectral signature and the reference spectral signature of the optical fiber (14) by detecting a shift between one of the characteristic wavelengths of one of the Bragg gratings (20) in the current spectral signature and in the reference spectral signature of the optical fiber (14).

7. Method for detecting a series arc, making use of a device according to one of the preceding claims in an electrical power distribution network of an aircraft, the method being **characterized in that** it comprises the following steps:
- emitting a reference optical signal, said reference optical signal being composed of an incident light spectrum including the characteristic wavelength of each Bragg grating (20) of the optical fiber (14), and receiving a reflected optical signal composed of a light spectrum reflected by the optical fiber (14) and defining a current spectral signature of the optical fiber (14),
- comparing said current spectral signature with a reference spectral signature by using the acquisition central processing unit (34), and detecting and locating an arc fault if there is such.

8. Method according to claim 7, further comprising the following step:
- in the event that an arc fault is detected at a connection interface member (38), sending an arc fault detection signal for an arc fault located at the connection interface member (38) in question, to a cut-off device in order to actuate said cut-off device.

9. Method according to claim 7 or 8, further comprising the following steps:
- before supplying power to the distribution route, emitting a reference optical signal, and receiving a reflected optical signal composed of a light spectrum reflected by the optical fiber (14) and defining the reference spectral signature of the optical fiber (14), and
- storing the reference spectral signature in the acquisition central processing unit (34).

10. Method according to one of claims 7 to 9, wherein the steps of emitting the reference optical signal and comparing the current spectral signature and the reference spectral signature are implemented continuously during the supply of power to the distribution route.

11. Method according to one of claims 7 to 10, wherein the detection of a possible arc fault is done by comparing the current spectral signature and the reference spectral signature, by measuring a shift of at least one characteristic wavelength of one of the Bragg gratings (20).

12. Method according to one of claims 7 to 11, wherein the step of comparing the spectral signature comprises implementing a segregation algorithm, capable of segregating a temperature change resulting from an arc fault from a temperature change resulting from an external cause.

13. Aircraft comprising an electrical power distribution network (10) according to one of claims 1 to 6.
